# EUROPEAN PATENT APPLICATION

(11) **EP 4 539 274 A2**
(43) Date of publication of application: **16.04.2025**
(21) Application number: 24204909.6
(22) Date of filing: 07.10.2024
(51) Int. Cl.: H01S 5/50

(54) **UNPOLARIZED OPTICAL SIGNAL AMPLIFICATION USING POLARIZATION-DEPENDENT GAIN OPTICAL AMPLIFIERS**

(30) Priority: 12.10.2023 US 202363589750 P
(71) Applicant: Denselight Semiconductors Pte Ltd, Singapore 498831 (SG)
(72) Inventor: KOH, Long Cheng, 600122 Singapore (SG); CHOO, Lay Cheng, 520893 Singapore (SG); SHU, Huade, Shanghai, 201419 (CN); PATMON, Bryan K., 486066 Singapore (SG); LAM, Yee Loy, 426094 Singapore (SG)
(74) Representative: Cabinet Chaillot

(57) **Abstract**

Provided are an optical amplification circuit, an optical amplification method, and an optical circuit for amplifying an unpolarized optical signal. The optical amplification circuit may include an input interface, a pair of optical amplifiers having Polarization-Dependent Gain (PDG) profiles, and an output interface. The input interface receives the unpolarized optical signal. The input interface outputs a first polarization component and a second polarization component based on the received unpolarized optical signal. The pair of optical amplifiers may amplify the first polarization component and the second polarization component based on the PDG profiles. The output interface may output an amplified version of the unpolarized optical signal based on the amplified first polarization component and the amplified second polarization component.

## Description

### CROSS-REFERENCE TO RELATED APPLICATIONS

This application claims priority to and the benefit of the provisional patent application titled "High-power Low Polarization Dependent Gain Semiconductor Optical Amplifier", application number 63/589,750, filed in the United States Patent and Trademark Office on October 12, 2023, which is incorporated herein by reference in its entirety.

### FIELD OF THE DISCLOSURE

The present disclosure generally relates to optical communication systems. More particularly, the present disclosure relates to amplifying unpolarized optical signals in the optical communication systems using polarization-dependent gain optical amplifiers.

### BACKGROUND

An optical communication system is a system that uses optical signals to exchange data over long distances. Usually, the optical communication system may include one or more optical amplifiers to compensate for power losses that occur during signal transmission. These optical amplifiers may receive an optical signal and output an amplified version of the received optical signal. The incoming optical signal is often unpolarized, containing multiple polarization states. Accordingly, the optical amplifiers used should be polarization-independent to effectively amplify unpolarized optical signals.

A commonly used Erbium-Doped Fiber Amplifier (EDFA) may be operated as a polarization-independent optical amplifier using various techniques such as polarization scrambling or polarization-maintaining components. This EDFA may contain an erbium-doped fiber and a pump laser source. The pump laser source may inject the incoming optical signal into the erbium-doped fiber to realize the amplification of the incoming optical signal. However, the combination of the erbium-doped fiber and the pump laser source may make the EDFA bulky, restricting its use in compact optical communication systems. Additionally, EDFAs are typically limited to the C-band wavelength range, further constraining their applications to optical communication systems that only operate within this range.

Accordingly, there is a need for a technical solution that overcomes the abovementioned problems. Limitations and disadvantages of conventional approaches will become apparent to one of skill in the art, through comparison of described systems with some aspects of the present disclosure, as outlined in the remainder of the present application and with reference to the drawings.

### SUMMARY OF THE DISCLOSURE

Various embodiments of the disclosure are provided herein to amplify unpolarized optical signals in optical communication systems. In one aspect of the disclosure, an optical amplification circuit for amplifying an unpolarized optical signal is provided. The optical amplification circuit comprises an input interface, a pair of optical amplifiers coupled to the input interface, and an output interface coupled to the pair of optical amplifiers. The input interface is configured to receive the unpolarized optical signal and output a first polarization component and a second polarization component based on the unpolarized optical signal. The pair of optical amplifiers has Polarization-Dependent Gain (PDG) profiles. The pair of optical amplifiers is configured to amplify the first polarization component and the second polarization component based on the PDG profiles. The output interface is configured to output an amplified version of the unpolarized optical signal based on the amplified first polarization component and the amplified second polarization component.

In some embodiments, the input interface includes a polarization splitter that is configured to split the unpolarized optical signal into the first polarization component and a third polarization component, where the third polarization component is orthogonal to the first polarization component. The input interface further includes a polarization shifter that is configured to convert the third polarization component to the second polarization component.

In some embodiments, each of the first polarization component and the second polarization component corresponds to a transverse electric (TE) mode component. The third polarization component corresponds to a transverse magnetic (TM) mode component.

In some embodiments, each PDG profile of the PDG profiles indicates that an optical gain of a respective optical amplifier of the pair of optical amplifiers is dominant for the TE mode component.

In some embodiments, the pair of optical amplifiers includes a first optical amplifier and a second optical amplifier. The input interface further includes an optical mirror. The polarization splitter is further configured to allow the third polarization component to pass therethrough toward the polarization shifter, and reflect the first polarization component toward the optical mirror. The polarization shifter is further configured to output the second polarization component to the first optical amplifier based on the conversion of the third polarization component. The optical mirror is configured to direct the first polarization component toward the second optical amplifier.

In some embodiments, each of the first polarization component and the second polarization component corresponds to the TM mode component. The third polarization component corresponds to the TE mode component.

In some embodiments, the pair of optical amplifiers includes the first optical amplifier and the second optical amplifier. The input interface further includes the optical mirror. The polarization splitter is configured to allow the first polarization component to pass therethrough toward the first optical amplifier, and reflect the third polarization component toward the optical mirror. The optical mirror is configured to direct the third polarization component toward the polarization shifter. The polarization shifter is configured to output the second polarization component to the second optical amplifier based on the conversion of the third polarization component.

In some embodiments, the first polarization component corresponds to the TM mode component, and the second polarization component corresponds to the TE mode component.

In some embodiments, the pair of optical amplifiers includes the first optical amplifier and the second optical amplifier. The input interface includes the polarization splitter and the optical mirror. The polarization splitter is configured to split the unpolarized optical signal into the first polarization component and the second polarization component. Further, the polarization splitter is configured to allow the first polarization component to pass therethrough toward the first optical amplifier and reflect the second polarization component toward the optical mirror. The optical mirror is configured to direct the second polarization component toward the second optical amplifier.

In some embodiments, the PDG profiles include a first PDG profile associated with the first optical amplifier and a second PDG profile associated with the second optical amplifier. The first PDG profile indicates that an optical gain of the first optical amplifier is dominant for the TM mode component. The second PDG profile indicates that an optical gain of the second optical amplifier is dominant for the TE mode component.

In some embodiments, the output interface includes an optical mirror and a polarization combiner. The optical mirror is configured to direct the amplified first polarization component toward the polarization combiner. The polarization combiner is configured to combine the amplified first polarization component and the amplified second polarization component. Further, the polarization combiner is configured to output the amplified version of the unpolarized optical signal based on the combination of the amplified first polarization component and the amplified second polarization component.

In some embodiments, the pair of optical amplifiers includes the first optical amplifier and the second optical amplifier. The output interface further includes the polarization shifter. The polarization shifter is between the first optical amplifier and the optical mirror or between the second optical amplifier and the polarization combiner.

In some embodiments, the pair of optical amplifiers includes a pair of Semiconductor Optical Amplifiers (SOAs).

In some embodiments, the optical amplification circuit further includes an amplification control circuit. The amplification control circuit is configured to generate a drive current for each SOA of the pair of SOAs and control, based on the generated drive current, the amplification of each SOA of the pair of SOAs.

In another aspect, an optical circuit for amplifying the unpolarized optical signal is provided. The optical circuit includes an optical splitter, a plurality of optical amplification circuits coupled to the optical splitter, and an optical combiner coupled to the plurality of optical amplification circuits. The optical splitter is configured to receive an unpolarized input optical signal having a set of characteristics. The optical splitter is further configured to split the unpolarized input optical signal into a plurality of unpolarized optical signals based on the set of characteristics. Each optical amplification circuit of the plurality of optical amplification circuits includes a pair of optical amplifiers having the PDG profiles. Each optical amplification circuit of the plurality of optical amplification circuits is configured to receive a respective unpolarized optical signal of the plurality of unpolarized optical signals. Further, each optical amplification circuit of the plurality of optical amplification circuits is configured to amplify the respective unpolarized optical signal based on the PDG profiles and output the respective amplified unpolarized optical signal of a plurality of amplified unpolarized optical signals. The optical combiner is configured to receive the plurality of amplified unpolarized optical signals. Further, the optical combiner is configured to combine the plurality of amplified unpolarized optical signals and output an amplified version of the unpolarized input optical signal based on the combination of the plurality of amplified unpolarized optical signals.

In some embodiments, the set of characteristics corresponds to at least one of a multi-wavelength band of the unpolarized input optical signal or a power level of the unpolarized input optical signal.

In some embodiments, each unpolarized optical signal of the plurality of unpolarized optical signals has a specific wavelength band in the multi-wavelength band of the unpolarized input optical signal.

In some embodiments, each unpolarized optical signal of the plurality of unpolarized optical signals has a specific power ratio relative to the power level of the unpolarized input optical signal.

In yet another aspect, an optical communication method for amplifying the unpolarized optical signal is provided. The optical communication method is implemented by the optical amplification circuit that includes the pair of optical amplifiers, where the pair of optical amplifiers has the PDG profiles. The optical communication method includes receiving the unpolarized optical signal and obtaining the first polarization component and the second polarization component based on the unpolarized optical signal. Further, the optical communication method includes amplifying the first polarization component and the second polarization component based on the PDG profiles. Furthermore, the optical communication method includes outputting an amplified version of the unpolarized optical signal based on the amplified first polarization component and the amplified second polarization component.

Some embodiments are based on the realization that an optical amplifier should be polarization-independent in order to effectively amplify the unpolarized optical signal. To this end, some embodiments of the present disclosure provide the optical amplification circuit that utilizes the pair of optical amplifiers having the PDG profiles. The utilization of the pair of optical amplifiers may enable the optical amplification circuit to function as a polarization-independent amplification circuit (or a low polarization-dependent amplification circuit). As used herein, the polarization-independent amplification circuit may correspond to an optical amplification circuit that allows for amplification of incoming unpolarized optical signals without discriminating between its TE and TM mode components. In some more embodiments, an optical circuit that utilizes multiple optical amplification circuits may be provided. The utilization of the optical amplification circuits may allow for the customization of each optical amplification circuit to a different wavelength band which in turn enables the optical circuit to be utilized in optical communication systems that operate in a broad wavelength band.

Other objects, advantages, novel features, and further scope of applicability of the present disclosure will be set forth in part in the detailed description to follow, and in part will become apparent to those skilled in the art upon examination of the following or may be learned by practice of the disclosure. Although the description above contains many specificities, these should not be construed as limiting the scope of the disclosure but as merely providing illustrations of some of the presently preferred embodiments of the disclosure. As such, various other embodiments are possible within its scope. Accordingly, the scope of the disclosure should be determined not by the embodiments illustrated, but by the appended claims and their equivalents.

### BRIEF DESCRIPTION OF THE DRAWINGS

Various embodiments of the present disclosure are illustrated by way of example, and not limited by the appended figures, in which like references indicate similar elements, and in which:
FIG. 1 is a diagram that illustrates a photonic device in accordance with various embodiments of the present disclosure;
FIG. 2 is a diagram that illustrates an optical amplification circuit in accordance with various embodiments of the present disclosure;
FIG. 3 is a diagram that illustrates another optical amplification circuit in accordance with various embodiments of the present disclosure;
FIG. 4 is a diagram that illustrates another optical amplification circuit in accordance with various embodiments of the present disclosure;
FIG. 5 is a diagram that illustrates an optical circuit in accordance with various embodiments of the present disclosure; and
FIG. 6 is a flowchart that illustrates an optical amplification method in accordance with various embodiments of the present disclosure.

### DETAILED DESCRIPTION

The present disclosure is best understood with reference to the detailed figures and description set forth herein. Various embodiments are discussed below with reference to the figures. However, those skilled in the art will readily appreciate that the detailed descriptions given herein with respect to the figures are simply for explanatory purposes as the methods and systems may extend beyond the described embodiments. In one example, the teachings presented and the needs of a particular application may yield multiple alternate and suitable approaches to implement the functionality of any detail described herein. Therefore, any approach may extend beyond the particular implementation choices in the following embodiments that are described and shown.

References to "an embodiment", "another embodiment", "yet another embodiment", "one example", "another example", "yet another example", "for example" and so on, indicate that the embodiment(s) or example(s) so described may include a particular feature, structure, characteristic, property, element, or limitation, but that not every embodiment or example necessarily includes that particular feature, structure, characteristic, property, element or limitation. Furthermore, repeated use of the phrase "in an embodiment" does not necessarily refer to the same embodiment.

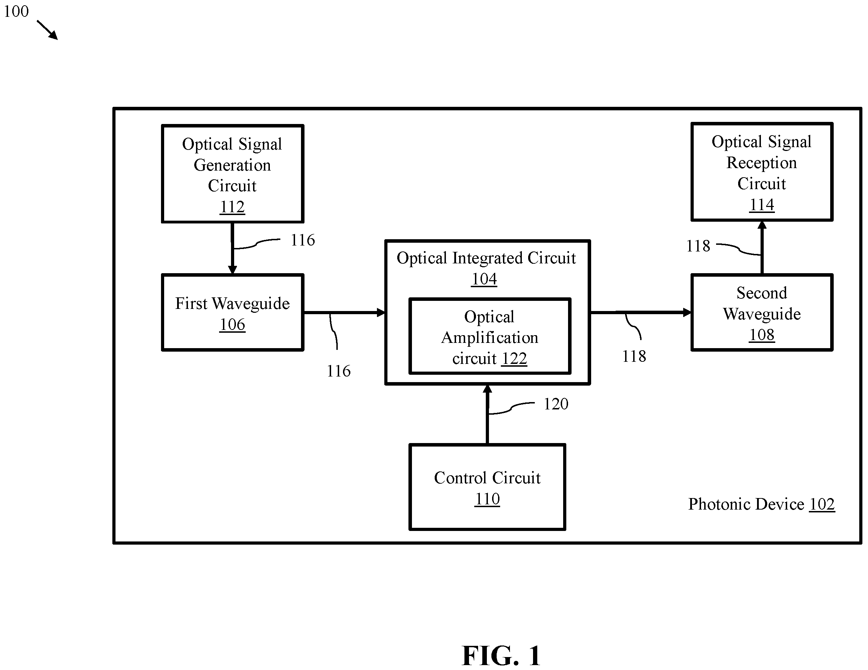

Referring to FIG. 1, a diagram 100 that illustrates a photonic device 102 in accordance with various embodiments of the present disclosure is shown. In a variety of embodiments, the photonic device 102 may include an optical Integrated Circuit (IC) 104, a first waveguide 106, a second waveguide 108, and a control circuit 110. Additionally, the photonic device 102 may include an optical signal generation circuit 112 and/or an optical signal reception circuit 114. As used herein, the optical signal generation circuit 112 may be a circuit (or a device) that converts electrical signals into optical signals for various applications, such as optical communication, data processing, or the like. In an example, the optical signal generation circuit 112 may include one or more light sources and a drive circuit. The drive circuit may generate and provide drive signals to the light sources in order to drive (or control) the light sources. The light sources may convert the electrical signals into the optical signals based on the drive signals. For example, the light sources may include Laser Diodes (LDs), Light-Emitting Diodes (LEDs), Vertical-Cavity Surface-Emitting Lasers (VCSELs), or the like.

As used herein, the optical signal reception circuit 114 may be a circuit (or a device) that converts the optical signals to the electrical signals for further processing or analysis. In an example, the optical signal reception circuit 114 may include at least one photodetector and at least one application processor. The photodetector may convert the optical signals to the electrical signals. For example, the photodetector may include a PIN photodiode, an avalanche photodiode, a phototransistor, a quantum dot photodetector, a Charge-Coupled Device (CCD), or the like. The application processor may execute, based on the electrical signals, various applications associated therewith. Although the optical signal generation circuit 112 and/or the optical signal reception circuit 114 are shown to be embodied in the photonic device 102, the scope of the present disclosure is not limited to it. In some example embodiments, the optical signal generation circuit 112 and/or the optical signal reception circuit 114 may be external to the photonic device 102 without deviating from the scope of the present disclosure.

In numerous embodiments, the first waveguide 106 and the second waveguide 108 may be coupled to the optical signal generation circuit 112 and the optical signal reception circuit 114, respectively. Further, the first waveguide 106 and the second waveguide 108 may be coupled to the optical IC 104. For example, the first waveguide 106 may include a first end that is coupled to the optical signal generation circuit 112 and a second end that is coupled to the optical IC 104. Similarly, the second waveguide 108 may include a first end that is coupled to the optical signal reception circuit 114 and a second end that is coupled to the optical IC 104.

In further embodiments, the first waveguide 106 may be configured to receive a first optical signal 116 from the optical signal generation circuit 112. Further, the first waveguide 106 may be configured to output the first optical signal 116 to the optical IC 104. The second waveguide 108 may be configured to receive a second optical signal 118 from the optical IC 104. Further, the second waveguide 108 may be configured to output the second optical signal 118 to the optical signal reception circuit 114. In an example, the second optical signal 118 may be an amplified version of the first optical signal 116. As used herein, the first waveguide 106 and the second waveguide 108 may correspond to optical fibers, planar waveguides, or the like. For example, the first waveguide 106 and the second waveguide 108 may be configured to allow the first optical signal 116 and the second optical signal 118 to pass through, respectively. In an example, each of the first waveguide 106 and the second waveguide 108 may include a Single-Mode Fiber (SMF), a Multimode Fiber (MMF), or the like. Although it is shown that the first waveguide 106 and the second waveguide 108 are directly coupled to the optical IC 104, the scope of the present disclosure is not limited to it. In some example embodiments, the first waveguide 106 and the second waveguide 108 may be coupled to the optical IC 104 by way of first and second lenses, respectively, without deviating from the scope of the present disclosure. For example, the first and second lenses may correspond to microlenses, Gradient-Index (GRIN) lenses, or the like.

In many embodiments, the control circuit 110 may be coupled to the optical IC 104. The control circuit 110 may be configured to generate and inject a drive current 120 into the optical IC 104. The injected drive current 120 may enable the optical IC 104 to output the second optical signal 118 based on the first optical signal 116. In an example, the drive current 120 may be a bias current, a modulation signal, or the like. Although it is shown that the control circuit 110 is embodied in the photonic device 102, the scope of the present disclosure is not limited to it. In some example embodiments, the control circuit 110 may be external to the photonic device 102, without deviating from the scope of the present disclosure.

In more embodiments, the optical IC 104 may be coupled to each of the first waveguide 106, the second waveguide 108, and/or the control circuit 110. The optical IC 104 may be configured to receive the first optical signal 116 from the first waveguide 106. In an embodiment, the optical IC 104 may include one or more input ports and one or more outport ports. The first optical signal 116 may be received via an input port of the input ports. Further, the optical IC 104 may be configured to output the second optical signal 118 to the second waveguide 108. In an example, the second optical signal 118 may be outputted via an output port of the outport ports. In several embodiments, to output the second optical signal 118, the optical IC 104 may be configured to amplify the first optical signal 116 based on the drive current 120 supplied by the control circuit 110. The second optical signal 118 may correspond to the amplified version of the first optical signal 116. The optical IC 104 may correspond to a gain chip, a tuneable laser, or the like.

Some embodiments are based on the recognition that the first optical signal 116 received by the optical IC 104 may correspond to an unpolarized optical signal. For example, the optical signal generation circuit 112 may generate and output the unpolarized optical signal as the first optical signal 116. Alternatively, the first optical signal 116 may become unpolarized after propagation through the first waveguide 106. As used herein, the unpolarized optical signal may correspond to an optical signal that contains a time-varying mixture of polarization mode components (e.g., a Transverse Electric (TE) mode component and a Transverse Magnetic (TM) mode component), without a specific predominance of one polarization mode component over the other.

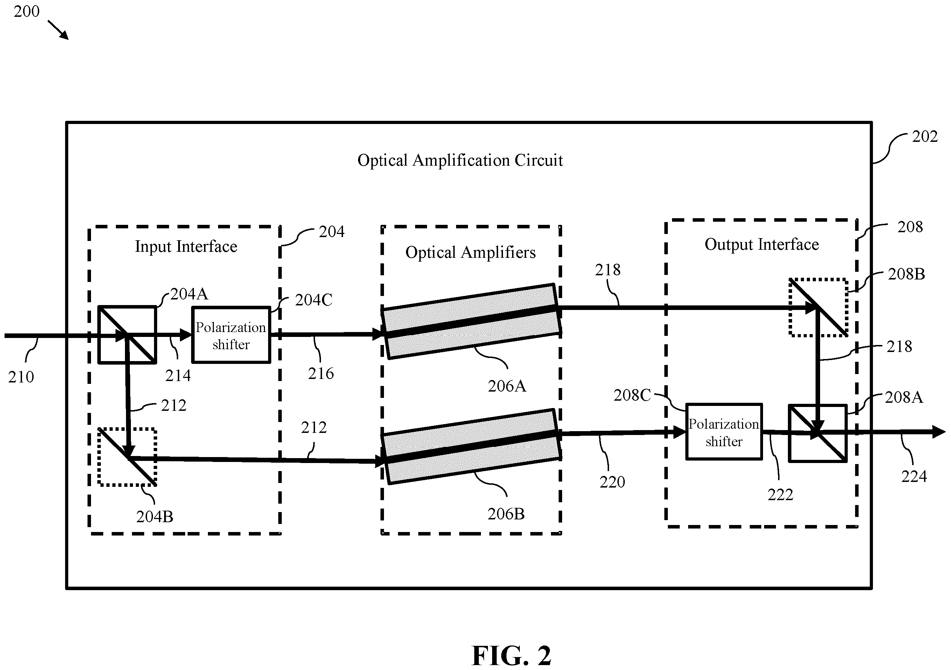

Some embodiments are based on the realization that the optical IC 104 should be polarization-independent to effectively amplify the unpolarized optical signal. To this end, the optical IC 104 may be provided with an optical amplification circuit 122. In various embodiments, the optical amplification circuit 122 may include multiple polarization-dependent gain optical amplifiers, which together enable the optical amplification circuit 122 to function as a polarization-independent amplification circuit (or a low polarization-dependent amplification circuit). As used herein, the polarization-independent amplification circuit may correspond to an optical amplification circuit that allows for amplification of incoming unpolarized optical signals without discriminating between its TE and TM mode components. The optical amplification circuit 122 is explained in detail in conjunction with FIG. 2-FIG. 5.

Referring to FIG. 2, a diagram 200 that illustrates an optical amplification circuit 202 in accordance with some example embodiments of the present disclosure is shown. FIG. 2 will be explained in conjunction with FIG. 1. The optical amplification circuit 202 may correspond to the optical amplification circuit 122 illustrated in FIG. 1. In the embodiments shown in FIG. 2, the optical amplification circuit 202 may include an input interface 204, a pair of optical amplifiers 206A and 206B, and an output interface 208. In a variety of embodiments, the input interface 204 may be configured to receive an unpolarized optical signal 210. In an embodiment, the optical amplification circuit 202 may include at least one input port and at least one output port. In an example embodiment, the input port may be coupled to an optical fiber that allows the unpolarized optical signal 210 to pass through. In this example embodiment, the unpolarized optical signal 210 may be received by the input interface 204 via the input port. In an example, the received unpolarized optical signal 210 may include a mixture of TE and TM mode components. In a number of embodiments, the input interface 204 may be further configured to output a first polarization component 212 and a second polarization component 216 based on the unpolarized optical signal 210. In order to output the first polarization component 212 and the second polarization component 216, the input interface 204 may include a polarization splitter 204A, an optical mirror 204B, and a polarization shifter 204C.

In numerous embodiments, the polarization splitter 204A may be positioned within the input interface 204 (or the optical amplification circuit 202) such that the polarization splitter 204A faces the input port of the optical amplification circuit 202. The polarization splitter 204A may be configured to split the unpolarized optical signal 210 into the first polarization component 212 and a third polarization component 214. The third polarization component 214 may be orthogonal to the first polarization component 212. For example, the first polarization component 212 and the third polarization component 214 may correspond to the TE and TM mode components of the unpolarized optical signal 210, respectively. In an embodiment, the polarization splitter 204A may correspond to a polarization beam splitter (e.g., a cube polarizing beam splitter, a plate polarizing beam splitter, or the like). The polarization splitter 204A may be further configured to allow the third polarization component 214 corresponding to the TM mode component to pass therethrough toward the polarization shifter 204C. Furthermore, the polarization splitter 204A may be configured to reflect the first polarization component 212 corresponding to the TE mode component toward the optical mirror 204B.

In many embodiments, the polarization shifter 204C may be positioned adjacent to the polarization splitter 204A such that the polarization shifter 204C receives the third polarization component 214. The polarization shifter 204C may be configured to convert the third polarization component 214 to the second polarization component 216. For example, the polarization shifter 204C may rotate a polarization plane of the third polarization component 214 and output the polarization plane rotated polarization component as the second polarization component 216. In an example, the polarization shifter 204C may rotate the polarization plane of the third polarization component 214 in such a manner that the second polarization component 216 is orthogonal to the third polarization component 214. For instance, if the third polarization component 214 corresponds to the TM mode component, the second polarization component 216 may correspond to the TE mode component. In an embodiment, the polarization shifter 204C may correspond to a waveplate, a Faraday rotator, or the like. In an example, the waveplate may correspond to a half-wave plate, a combination of two quarter-wave plates, or the like. The polarization shifter 204C may be further configured to direct the second polarization component 216 toward a first optical amplifier 206A of the pair of optical amplifiers 206A and 206B.

In further embodiments, the optical mirror 204B may be positioned below the polarization splitter 204A such that the optical mirror 204B receives the first polarization component 212 reflected by the polarization splitter 204A. The optical mirror 204B may be configured to direct the first polarization component 212 toward a second optical amplifier 206B of the pair of optical amplifiers 206A and 206B. For example, the optical mirror 204B may reflect the received first polarization component 212 by 90°, in order to direct the first polarization component 212 toward the second optical amplifier 206B. In an embodiment, the optical mirror 204B may correspond to a right-angle prism, a mirror assembly having a single flat mirror positioned at a 45° angle to the first polarization component 212, or the like.

In more embodiments, the pair of optical amplifiers 206A and 206B may be coupled to the input interface 204. For example, the pair of optical amplifiers 206A and 206B may be coupled to the input interface 204 by optical fibers, Numerical Aperture (NA) matched optical lenses, or the like. The pair of optical amplifiers 206A and 206B may be positioned between the input interface 204 and the output interface 208. Specifically, the first optical amplifier 206A may be positioned in such a way that the first optical amplifier 206A faces the polarization shifter 204C for receiving the second polarization component 216. Similarly, the second optical amplifier 206B may be positioned to face the optical mirror 204B for receiving the first polarization component 212. The first optical amplifier 206A and the second optical amplifier 206B may be configured to amplify the second polarization component 216 and the first polarization component 212, respectively. For example, in order to amplify the second polarization component 216, the first optical amplifier 206A may increase an optical signal strength and/or a power level of the second polarization component 216. Similarly, in order to amplify the first polarization component 212, the second optical amplifier 206B may increase an optical signal strength and/or a power level of the first polarization component 212.

In still more embodiments, the pair of optical amplifiers 206A and 206B may correspond to a pair of Semiconductor Optical Amplifiers (SOAs). Hereinafter, the pair of optical amplifiers 206A and 206B may be referred to as the pair of SOAs 206A and 206B. In several embodiments, the optical amplification circuit 202 may further include (or may be further coupled to) at least one amplification control circuit. In an example, the amplification control circuit may correspond to the control circuit 110 shown in FIG. 1. In an embodiment, the amplification control circuit may be configured to control the amplification of each SOA of the pair of SOAs 206A and 206B to obtain a specific optical gain from a respective SOA of the pair of SOAs 206A and 206B. For example, the amplification control circuit may control the amplification of each SOA of the pair of SOAs 206A and 206B for increasing the optical signal strengths (or the power levels) of the first polarization component 212 and the second polarization component 216 to specific optical signal strengths (or specific power levels). In order to control the amplification, the amplification control circuit may generate a drive current for each SOA of the pair of SOAs 206A and 206B, and inject the generated drive current to the respective SOA of the pair of SOAs 206A and 206B. For example, the generated drive current may correspond to a bias current, a modulation signal, or the like.

In several more embodiments, each SOA of the pair of SOAs 206A and 206B may include an optical gain waveguide having multiple quantum well structures. In numerous more embodiments, by designing the quantum well structures, the optical gain of each SOA of the pair of SOAs 206A and 206B may be tailored for one of the TE or TM mode components for a given drive current. For example, by varying the number of quantum well structures, sizes of the quantum well structures, and/or strained designs of the quantum well structures, the optical gain of each SOA of the pair of SOAs 206A and 206B may be tailored for one of the TE or TM mode components. Accordingly, in these embodiments, the pair of SOAs 206A and 206B may correspond to a pair of Polarization-Dependent Gain (PDG) optical amplifiers having PDG profiles. For example, each PDG profile of the PDG profiles may include a PDG of a respective SOA of the pair of SOAs 206A and 206B for the given drive current. In an example, the PDG of a particular SOA (e.g., the SOA 206A or 206B) may correspond to a ratio of optical gains obtained by the particular SOA for the TE and TM mode components. The PDG of the particular SOA may indicate whether the optical gain of the particular SOA is dominant in the TE mode component or the TM mode component. For the embodiments shown in FIG. 2, the optical gains of the pair of SOAs 206A and 206B may be tailored for the TE mode component. As a result, the PDG profiles of the pair of SOAs 206A and 206B may indicate the optical gains of the pair of SOAs 206A and 206B are dominant for the TE mode component.

In a variety of embodiments, the optical gain waveguide included in each SOA of the pair of SOAs 206A and 206B may include a waveguide input port and a waveguide output port. In a number of embodiments, the first SOA 206A may receive the second polarization component 216 corresponding to the TE mode component via the waveguide input port. Further, the first SOA 206A may amplify the second polarization component 216 based on the PDG profile of the first SOA 206A. Furthermore, the first SOA 206A may output, based on the amplification, an amplified second polarization component 218 via the waveguide output port. Similarly, the second SOA 206B may output an amplified first polarization component 220 by amplifying the first polarization component 212 using the PDG profile of the second SOA 206B. In some embodiments, optical facets of the waveguide input port and output ports may be coated with Anti-Reflection (AR) optical films to suppress back-reflection, optical feedback, or the like.

In various embodiments, the output interface 208 may be coupled to the pair of SOAs 206A and 206B. For instance, the optical fibers may be utilized to couple the output interface 208 to the pair of SOAs 206A and 206B. The output interface 208 may be configured to output an unpolarized optical signal 224 based on the amplified first polarization component 220 and the amplified second polarization component 218. For example, the unpolarized optical signal 224 may correspond to an amplified version of the unpolarized optical signal 210. In order to output the unpolarized optical signal 224, the output interface 208 may include a polarization combiner 208A, an optical mirror 208B, and a polarization shifter 208C.

In several embodiments, the optical mirror 208B may be positioned within the output interface 208 (or the optical amplification circuit 202) such that the optical mirror 208B faces the first SOA 206A for receiving the amplified second polarization component 218. The optical mirror 208B may be configured to direct the amplified second polarization component 218 toward the polarization combiner 208A. For example, the optical mirror 208B may reflect the amplified second polarization component 218 by 90°, in order to direct the amplified second polarization component 218 toward the polarization combiner 208A. In an embodiment, the optical mirror 208B may correspond to the right-angle prism, the mirror assembly, or the like.

In many embodiments, the polarization shifter 208C may be positioned within the output interface 208 (or the optical amplification circuit 202) such that the polarization shifter 208C faces the second SOA 206B for receiving the amplified first polarization component 220. The polarization shifter 208C may be configured to convert the amplified first polarization component 220 to an amplified third polarization component 222. In an example, the amplified third polarization component 222 may be orthogonal to the amplified first polarization component 220. For instance, if the amplified first polarization component 220 corresponds to the TE mode component, the amplified third polarization component 222 may correspond to the TM mode component. In an embodiment, the polarization shifter 208C may correspond to the waveplate, the Faraday rotator, or the like. The polarization shifter 208C may be further configured to direct the amplified third polarization component 222 toward the polarization combiner 208A.

In numerous embodiments, the polarization combiner 208A may be positioned below the optical mirror 208B and adjacent to the polarization shifter 208C such that the polarization combiner 208A receives the amplified second polarization component 218 and the amplified third polarization component 222. In an embodiment, the polarization combiner 208A may be a polarization beam combiner that is configured to combine the amplified second polarization component 218 corresponding to the TE mode component with the amplified third polarization component 222 corresponding to the TM mode component. Further, the polarization combiner 208A may output the unpolarized optical signal 224 based on the combination of the amplified second polarization component 218 and the amplified third polarization component 222. In an example, the polarization combiner 208A may output the unpolarized optical signal 224 via the output port of the optical amplification circuit 202. For example, the unpolarized optical signal 224 may correspond to the amplified version of the unpolarized optical signal 210.

In this way, the pair of SOAs 206A and 206B along with the input interface 204 and the output interface 208 may enable the optical amplification circuit 202 to function as the polarization-independent amplification circuit for amplifying the unpolarized optical signal 210. Since the optical amplification circuit 202 does not utilize bulky optics (such as a pump laser source utilized by conventional devices), the optical amplification circuit 202 may be compact and may not restrict its use in compact optical communication systems. For instance, the optical amplification circuit 202 may be utilized in optical communication systems such as a continuous wave drive system, a power modulation drive system, or the like. Further, the utilization of the pair of SOAs 206A and 206B may enable the optical amplification circuit 202 to independently control the optical gains of the TE and TM mode components by independently tunning the drive currents of the pair of SOAs 206A and 206B. This independent control of the optical gains may enable the optical amplification circuit 202 to encode the incoming optical signal (e.g., the unpolarized optical signal 210) based on its TE and TM mode components. Accordingly, the optical amplification circuit 202 may be utilized in various security optical communication systems.

Some embodiments are based on the recognition that the utilization of the optical mirrors 204B and 208B and the polarization shifters 204C and 208C may lead to optical losses. To this end, in the embodiments shown in FIG. 2, the TE and TM mode components input towards the pair of SOA 206A and 206B are interchanged at the output of the optical amplification circuit 202 to provide a symmetrical optical loss. For instance, in order to interchange the TE and TM mode components, the optical mirror 208B and the polarization shifter 208C may be diagonally positioned within the output interface 208, with respect to the optical mirror 204B and the polarization shifter 204C, respectively. In certain embodiments, the symmetrical optical loss may be compensated by tuning the optical gains of the pair of SOA 206A and 206B.

Although it is shown that the polarization shifter 208C is positioned between the second SOA 206B and the polarization combiner 208A, the scope of the present disclosure is not limited to it. In some example embodiments, the polarization shifter 208C may be positioned between the first SOA 206A and the optical mirror 208B. In these embodiments, the optical losses may be compensated by independently tunning the optical gains of the pair of SOA 206A and 206B.

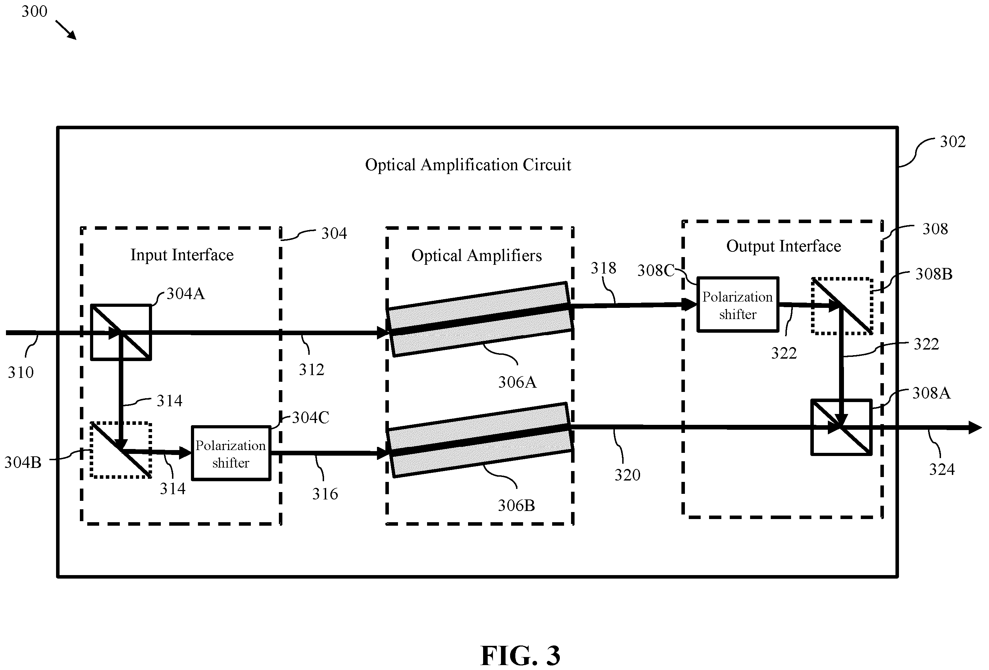

Although it is shown that the polarization shifter 204C is positioned between the polarization splitter 204A and the first SOA 206A, the scope of the present disclosure is not limited to it. In some more embodiments, the polarization shifter 204C may be positioned between the optical mirror 204B and the second SOA 206B if the PDG profiles of the pair of SOAs 206A and 206B indicate that the optical gains of the pair of SOAs 206A and 206B are dominant for the TM mode component. Alternatively, the polarization shifter 204C may be positioned between the optical mirror 204B and the second SOA 206B if the polarization splitter 204A allows the first polarization component 212 corresponding to the TE mode component to pass therethrough toward the first SOA 206A and reflects the third polarization component 214 corresponding to the TM mode component. The optical amplification circuit 202 with the polarization shifter 204C positioned between the optical mirror 204B and the second SOA 206B is explained in detail in conjunction with FIG. 3.

Referring to FIG. 3, a diagram 300 that illustrates an optical amplification circuit 302 in accordance with various embodiments of the present disclosure is shown. FIG. 3 will be explained in conjunction with FIG. 1 and FIG. 2. The optical amplification circuit 302 may correspond to the optical amplification circuit 122 illustrated in FIG. 1. In the embodiments shown in FIG. 3, the optical amplification circuit 302 may include an input interface 304, a pair of optical amplifiers 306A and 306B, and an output interface 308. In a variety of embodiments, the input interface 304 may be configured to receive an unpolarized optical signal 310. In an example, the unpolarized optical signal 310 may include the TE and TM mode components. The input interface 304 may be further configured to output a first polarization component 312 and a second polarization component 316 based on the unpolarized optical signal 310. In order to output the first polarization component 312 and the second polarization component 316, the input interface 304 may include a polarization splitter 304A, an optical mirror 304B, and a polarization shifter 304C.

In numerous embodiments, the polarization splitter 304A may be positioned within the input interface 304 in such a way that the polarization splitter 304A receives the unpolarized optical signal 310. The polarization splitter 304A may be configured to split the unpolarized optical signal 310 into the first polarization component 312 and a third polarization component 314. The third polarization component 314 may be orthogonal to the first polarization component 312. For example, the first polarization component 312 and the third polarization component 314 may correspond to the TM and TE mode components, respectively. The polarization splitter 304A may be further configured to allow the first polarization component 312 corresponding to the TM mode component to pass therethrough toward a first optical amplifier 306A of the pair of optical amplifiers 306A and 306B. Furthermore, the polarization splitter 304A may be configured to reflect the third polarization component 314 corresponding to the TE mode component toward the optical mirror 304B.

In further embodiments, the optical mirror 304B may be positioned below the polarization splitter 304A such that the optical mirror 304B receives the third polarization component 314 reflected by the polarization splitter 304A. The optical mirror 304B may be configured to direct the third polarization component 314 toward the polarization shifter 304C. For example, the optical mirror 304B may reflect the received third polarization component 314 by 90°, in order to direct the third polarization component 314 toward the polarization shifter 304C.

In many embodiments, the polarization shifter 304C may be positioned adjacent to the optical mirror 304B such that the polarization shifter 304C receives the third polarization component 314. The polarization shifter 304C may be configured to convert the third polarization component 314 to the second polarization component 316. In an example, the second polarization component 316 may be orthogonal to the third polarization component 314. For instance, if the third polarization component 314 corresponds to the TE mode component, the second polarization component 316 may correspond to the TM mode component. The polarization shifter 304C may be further configured to direct the second polarization component 316 toward a second optical amplifier 306B of the pair of optical amplifiers 306A and 306B.

In more embodiments, the pair of optical amplifiers 306A and 306B may be positioned between the input interface 304 and the output interface 308. Specifically, the first optical amplifier 306A may be positioned in such a way that the first optical amplifier 306A faces the polarization splitter 304A for receiving the first polarization component 312. Further, the second optical amplifier 306B may be positioned in such a way that the second optical amplifier 306B faces the polarization shifter 304C for receiving the second polarization component 316. The first optical amplifier 306A and the second optical amplifier 306B may be configured to amplify the first polarization component 312 and the second polarization component 316, respectively.

In still more embodiments, the pair of optical amplifiers 306A and 306B may correspond to the pair of SOAs having the PDG profiles. For the embodiments shown in FIG. 3, each PDG profile of the PDG profiles may indicate that an optical gain of a respective optical amplifier of the pair of optical amplifiers 306A and 306B is dominant for the TM mode component. In a variety of embodiments, the pair of optical amplifiers 306A and 306B may amplify the first polarization component 312 and the second polarization component 316 based on the PDG profiles. For example, the first optical amplifier 306A may amplify the first polarization component 312 based on the PDG profile of the first optical amplifier 306A. Further, the first optical amplifier 306A may output an amplified first polarization component 318 based on the amplification of the first polarization component 312. Similarly, the second optical amplifier 306B may output an amplified second polarization component 320 by amplifying the second polarization component 316 using the PDG profile of the second optical amplifier 306B.

In various embodiments, the output interface 308 may be configured to receive the amplified first polarization component 318 and the amplified second polarization component 320 and output an unpolarized optical signal 324. For example, the unpolarized optical signal 324 may correspond to an amplified version of the unpolarized optical signal 310. In order to output the unpolarized optical signal 324, the output interface 308 may include a polarization combiner 308A, an optical mirror 308B, and a polarization shifter 308C.

In a variety of embodiments, the polarization shifter 308C may be positioned within the output interface 308 such that the polarization shifter 308C faces the first optical amplifier 306A for receiving the amplified first polarization component 318. The polarization shifter 308C may be configured to convert the amplified first polarization component 318 to an amplified third polarization component 322. In an example, the amplified third polarization component 322 may be orthogonal to the amplified first polarization component 318. For instance, if the amplified first polarization component 318 corresponds to the TM mode component, the amplified third polarization component 322 may correspond to the TE mode component. The polarization shifter 308C may be further configured to direct the amplified third polarization component 322 toward the optical mirror 308B.

In several embodiments, the optical mirror 308B may be positioned adjacent to the polarization shifter 308C such that the optical mirror 308B receives the amplified third polarization component 322. The optical mirror 308B may be configured to direct the amplified third polarization component 322 toward the polarization combiner 308A. For example, the optical mirror 308B may reflect the amplified third polarization component 322 by 90°, in order to direct the amplified third polarization component 322 toward the polarization combiner 308A.

In several more embodiments, the polarization combiner 308A may be positioned below the optical mirror 308B in such a way that the polarization combiner 308A faces the second optical amplifier 306B. The polarization combiner 308A may be configured to receive the amplified second polarization component 320 and the amplified third polarization component 322. Further, the polarization combiner 308A may be configured to combine the amplified second polarization component 320 corresponding to the TM mode component with the amplified third polarization component 322 corresponding to the TE mode component. Furthermore, the polarization combiner 308A may output the unpolarized optical signal 324 based on the combination of the amplified second polarization component 320 and the amplified third polarization component 322. For example, the unpolarized optical signal 324 may correspond to the amplified version of the unpolarized optical signal 310.

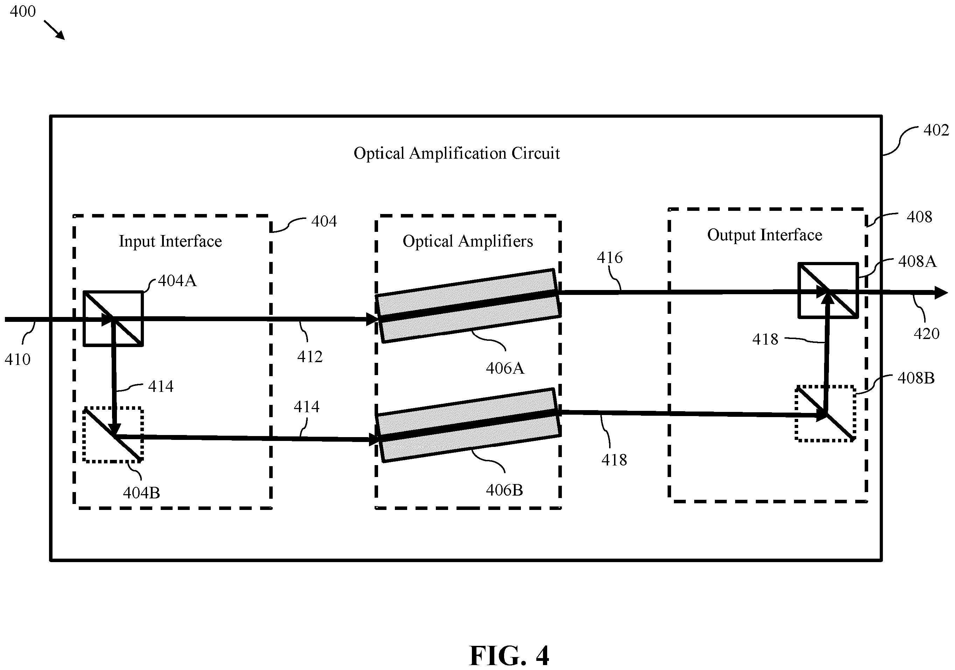

In this way, the pair of optical amplifiers 306A and 306B along with the input interface 304 and the output interface 308 may enable the optical amplification circuit 302 to function as the polarization-independent amplification circuit for amplifying the unpolarized optical signal 310. Although it is shown that the input interface 304 and the output interface 308 include the polarization shifters 304C and 308C, respectively, the scope of the present disclosure is not limited to it. In some more embodiments, the input interface 304 and the output interface 308 may not include the polarization shifters 304C and 308C as shown in FIG. 4.

Referring to FIG. 4, a diagram 400 that illustrates an optical amplification circuit 402 in accordance with various embodiments of the present disclosure is shown. FIG. 4 will be explained in conjunction with FIG. 1 - FIG. 3. The optical amplification circuit 402 may correspond to the optical amplification circuit 122 illustrated in FIG. 1. In the embodiments shown in FIG. 4, the optical amplification circuit 402 may include an input interface 404, a pair of optical amplifiers 406A and 406B, and an output interface 408. In a variety of embodiments, the input interface 404 may be configured to receive an unpolarized optical signal 410. In an example, the unpolarized optical signal 410 may include the TE and TM mode components. The input interface 404 may be further configured to output a first polarization component 412 and a second polarization component 414 based on the unpolarized optical signal 410. In order to output the first polarization component 412 and the second polarization component 414, the input interface 404 may include a polarization splitter 404A and an optical mirror 404B.

In numerous embodiments, the polarization splitter 404A may be positioned within the input interface 404 in such a way that the polarization splitter 404A receives the unpolarized optical signal 410. The polarization splitter 404A may be configured to split the unpolarized optical signal 410 into the first polarization component 412 and the second polarization component 414. For example, the second polarization component 414 may be orthogonal to the first polarization component 412. In an example, the first polarization component 412 and the second polarization component 414 may correspond to the TM and TE mode components, respectively. The polarization splitter 404A may be further configured to allow the first polarization component 412 corresponding to the TM mode component to pass therethrough toward a first optical amplifier 406A of the pair of optical amplifiers 406A and 406B. Furthermore, the polarization splitter 404A may be configured to reflect the second polarization component 414 corresponding to the TE mode component toward the optical mirror 404B.

In many embodiments, the optical mirror 404B may be positioned below the polarization splitter 404A such that the optical mirror 404B receives the second polarization component 414 reflected by the polarization splitter 404A. The optical mirror 404B may be configured to direct the second polarization component 414 toward a second optical amplifier 406B of the pair of optical amplifiers 406A and 406B. For example, the optical mirror 404B may reflect the received second polarization component 414 by 90°, in order to direct the second polarization component 414 toward the second optical amplifier 406B.

In more embodiments, the pair of optical amplifiers 406A and 406B may be positioned between the input interface 404 and the output interface 408. Specifically, the first optical amplifier 406A may be positioned in such a way that the first optical amplifier 406A faces the polarization splitter 404A for receiving the first polarization component 412. Further, the second optical amplifier 406B may be positioned in such a way that the second optical amplifier 406B faces the optical mirror 404B for receiving the second polarization component 414. The first optical amplifier 406A and the second optical amplifier 406B may be configured to amplify the first polarization component 412 and the second polarization component 414, respectively.

In still more embodiments, the pair of optical amplifiers 406A and 406B may correspond to the pair of SOAs having the PDG profiles. The PDG profiles may include a first PDG profile for the first optical amplifier 406A and a second PDG profile for the second optical amplifier 406B. For the embodiments shown in FIG. 4, the first PDG profile may indicate that an optical gain of the first optical amplifier 406A is dominant for the TM mode component and the second PDG profile may indicate that an optical gain of the second optical amplifier 406B is dominant for the TE mode component. In a variety of embodiments, the pair of optical amplifiers 406A and 406B may amplify the first polarization component 412 and the second polarization component 414 based on the PDG profiles. For example, the first optical amplifier 406A may amplify the first polarization component 412 based on the first PDG profile. Further, the first optical amplifier 406A may output an amplified first polarization component 416 based on the amplification of the first polarization component 412. Similarly, the second optical amplifier 406B may output an amplified second polarization component 418 by amplifying the second polarization component 414 using the second PDG profile.

In various embodiments, the output interface 408 may be configured to receive the amplified first polarization component 416 and the amplified second polarization component 418 and output an unpolarized optical signal 420. For example, the unpolarized optical signal 420 may correspond to an amplified version of the unpolarized optical signal 410. In order to output the unpolarized optical signal 420, the output interface 408 may include a polarization combiner 408A and an optical mirror 408B.

In several embodiments, the optical mirror 408B may be positioned within the output interface 408 in such a way that the optical mirror 408B faces the second optical amplifier 406B for receiving the amplified second polarization component 418. The optical mirror 408B may be configured to direct the amplified second polarization component 418 toward the polarization combiner 408A. For example, the optical mirror 408B may reflect the amplified second polarization component 418 by 90°, in order to direct the amplified second polarization component 418 toward the polarization combiner 408A.

In several more embodiments, the polarization combiner 408A may be positioned above the optical mirror 408B in such a way that the polarization combiner 408A faces the first optical amplifier 406A. The polarization combiner 408A may receive the amplified first polarization component 416 and the amplified second polarization component 418. Further, the polarization combiner 408A may be configured to combine the amplified first polarization component 416 corresponding to the TM mode component with the amplified second polarization component 418 corresponding to the TE mode component. Furthermore, the polarization combiner 408A may output the unpolarized optical signal 420 based on the combination of the amplified first polarization component 416 and the amplified second polarization component 418. For example, the unpolarized optical signal 420 may correspond to the amplified version of the unpolarized optical signal 410.

In this way, the pair of optical amplifiers 406A and 406B along with the input interface 404 and the output interface 408 may enable the optical amplification circuit 402 to function as the polarization-independent amplification circuit for amplifying the unpolarized optical signal 410. Although it is shown that the polarization combiner 408A and the optical mirror 408B face the first and second optical amplifiers 406A and 406B, respectively, the scope of the present disclosure is not limited to it. In some examples, the positions of the polarization combiner 408A and the optical mirror 408B may be swapped without deviating from the scope of the present disclosure, if the positions of the polarization splitter 404A and the optical mirror 404B are correspondingly swapped in the input interface 404. In some more examples, the positions of the polarization combiner 408A and the optical mirror 408B may be swapped without deviating from the scope of the present disclosure in order to provide the symmetrical optical loss, at least with respect to the optical mirrors 404B and 408B.

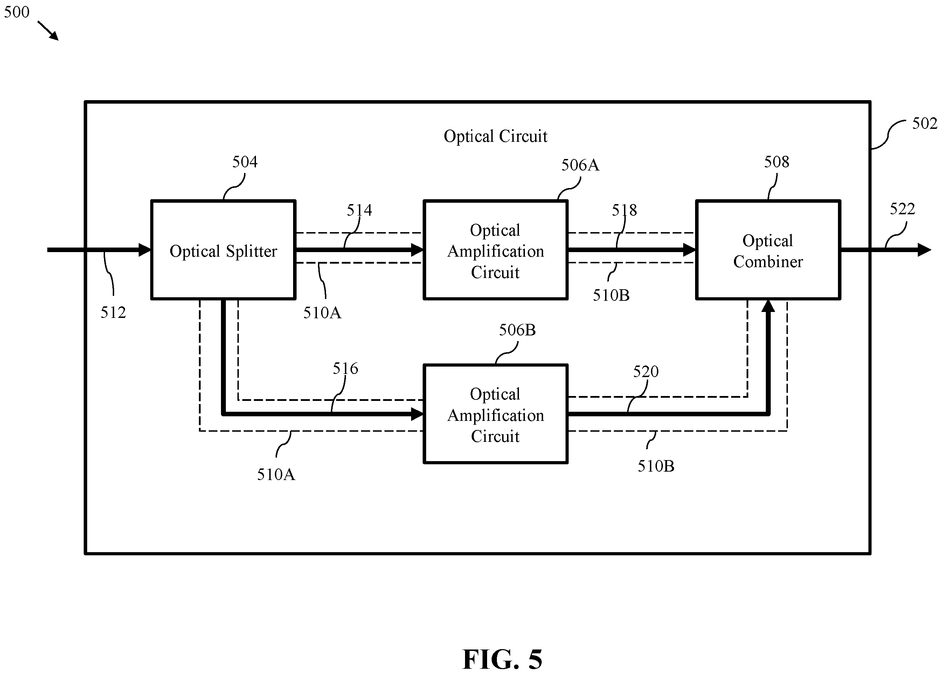

Some embodiments are based on the recognition that the optical amplification circuit 402 may provide an optimal optical gain if the optical amplification circuit 402 is operated in a specific wavelength band. For example, the specific wavelength band may correspond to one of the C-band (Conventional Band), the L-band (Long Wavelength Band), or the like. Therefore, in order to achieve the optimal optical gain for a broad wavelength band, the present disclosure provides an optical circuit. For example, the optical circuit may be designed to utilize multiple optical amplification circuits, where each optical amplification circuit is customized for a different wavelength band of the broad wavelength band. The optical circuit is explained in detail in conjunction with FIG. 5.

Referring to FIG. 5, a diagram 500 that illustrates an optical circuit 502 in accordance with various embodiments of the present disclosure is shown. FIG. 5 will be explained in conjunction with FIG. 1 - FIG. 4. In a variety of embodiments, the optical circuit 502 may be embodied in the optical IC 104 illustrated in FIG. 1. In the embodiments shown in FIG. 5, the optical circuit 502 may include an optical splitter 504, optical amplification circuits 506A and 506B, an optical combiner 508, and waveguides 510A and 510B. In numerous embodiments, the optical splitter 504 may be configured to receive an unpolarized input optical signal 512. In an embodiment, the optical splitter 504 may include at least one input port and a plurality of output ports. The optical splitter 504 may receive the unpolarized input optical signal 512 via its input port. In an example, the unpolarized input optical signal 512 may have a set of characteristics. For example, the set of characteristics may correspond to at least one of a multi-wavelength band of the unpolarized input optical signal 512 or a specific power level of the unpolarized input optical signal 512.

In numerous more embodiments, the optical splitter 504 may be configured to split the unpolarized input optical signal 512 into unpolarized optical signals 514 and 516 based on the set of characteristics. In some embodiments, the optical splitter 504 may correspond to a Wavelength Division Demultiplexer (WDM Demux) that splits the unpolarized input optical signal 512 into the unpolarized optical signals 514 and 516 based on the multi-wavelength band of the unpolarized input optical signal 512. In an example, the WDM Demux may split the unpolarized input optical signal 512 into the unpolarized optical signals 514 and 516 such that each unpolarized optical signal of the unpolarized optical signals 514 and 516 has a different wavelength band in the multi-wavelength band of the unpolarized input optical signal 512. For example, if the unpolarized input optical signal 512 corresponds to a composite optical signal having at least one wavelength in the C-band and at least one wavelength in the L-band, the WDM Demux may split the unpolarized input optical signal 512 into the unpolarized optical signal 514 having the wavelength in the C-band and the unpolarized optical signal 516 having the wavelength in the L-band.

In some more embodiments, the optical splitter 504 may correspond to a power splitter that splits the unpolarized input optical signal 512 into the unpolarized optical signals 514 and 516 based on the specific power level of the unpolarized input optical signal 512. In an example, the power splitter may split the unpolarized input optical signal 512 into the unpolarized optical signals 514 and 516 such that each unpolarized optical signal of the unpolarized optical signals 514 and 516 has a specific power ratio relative to the power level of the unpolarized input optical signal 512. For example, the specific power ratio of each unpolarized optical signal of the unpolarized optical signals 514 and 516 may be 0.5. Upon splitting the unpolarized input optical signal 512, the optical splitter 504 may output the unpolarized optical signals 514 and 516 toward the optical amplification circuits 506A and 506B via its plurality of output ports.

In many embodiments, the optical amplification circuits 506A and 506B may be coupled to the optical splitter 504. In an example, the optical amplification circuits 506A and 506B may be coupled to the optical splitter 504 by the waveguide 510A. For example, the waveguide 510A may correspond to the first waveguide 106 described in the detailed description of FIG. 1. In an embodiment, the optical amplification circuits 506A and 506B may be customized to operate in the C-band and the L-band, respectively, in order to amplify the unpolarized optical signals 514 and 516.

In still many embodiments, each optical amplification circuit of the optical amplification circuits 506A and 506B may include an input interface, a pair of optical amplifiers having the PDG profiles, and an output interface. In these embodiments, each optical amplification circuit of the optical amplification circuits 506A and 506B may be configured to receive a respective unpolarized optical signal of the unpolarized optical signals 514 and 516. For example, the optical amplification circuits 506A and 506B may receive the unpolarized optical signals 514 and 516, respectively. Further, each optical amplification circuit of the optical amplification circuits 506A and 506B may be configured to amplify the respective unpolarized optical signal based on its corresponding PDG profiles. Furthermore, each optical amplification circuit of the optical amplification circuits 506A and 506B may be configured to output the respective amplified unpolarized optical signal based on the amplification. For example, the optical amplification circuits 506A and 506B may output amplified unpolarized optical signals 518 and 520, respectively. In an example, the amplified unpolarized optical signals 518 and 520 may correspond to an amplified version of the unpolarized optical signals 514 and 516, respectively. For instance, each optical amplification circuit of the optical amplification circuits 506A and 506B may correspond to one of the optical amplification circuits 202, 302, or 402 described in the detailed description of FIG. 2 -FIG. 4, respectively.

In more embodiments, the optical amplification circuits 506A and 506B may be further coupled to the optical combiner 508 via the waveguide 510B. For example, the waveguide 510B may correspond to the second waveguide 108 described in the detailed description of FIG. 1. The optical combiner 508 may include a plurality of input ports and at least one output port. In various embodiments, the optical combiner 508 may be configured to receive the amplified unpolarized optical signals 518 and 520. For example, the optical combiner 508 may receive the amplified unpolarized optical signals 518 and 520 from the optical amplification circuits 506A and 506B via its plurality of input ports. Further, the optical combiner 508 may be configured to output an unpolarized output optical signal 522 by combining the amplified unpolarized optical signals 518 and 520. In some embodiments, the optical combiner 508 may correspond to a Wavelength Division Multiplexer (WDM) that combines the amplified unpolarized optical signals 518 and 520 based on their wavelengths in order to output the unpolarized output optical signal 522. In some other embodiments, the optical combiner 508 may correspond to a power combiner that combines the amplified unpolarized optical signals 518 and 520 based on their power levels in order to output the unpolarized output optical signal 522. In an example, the unpolarized output optical signal 522 may correspond to an amplified version of the unpolarized input optical signal 512.

In this way, the optical amplification circuits 506A and 506B may be utilized in the optical circuit 502 in order to provide the optimal optical gain for the broad wavelength band. Although it is shown that the optical circuit 502 includes two optical amplification circuits 506A and 506B for providing the optimal optical gain for the broad wavelength band, the scope of the present disclosure is not limited to it. In certain embodiments, the optical circuit 502 may include a plurality of optical amplification circuits if the incoming unpolarized optical signal (e.g., the unpolarized input optical signal 512) has wavelengths of a plurality of wavelength bands.

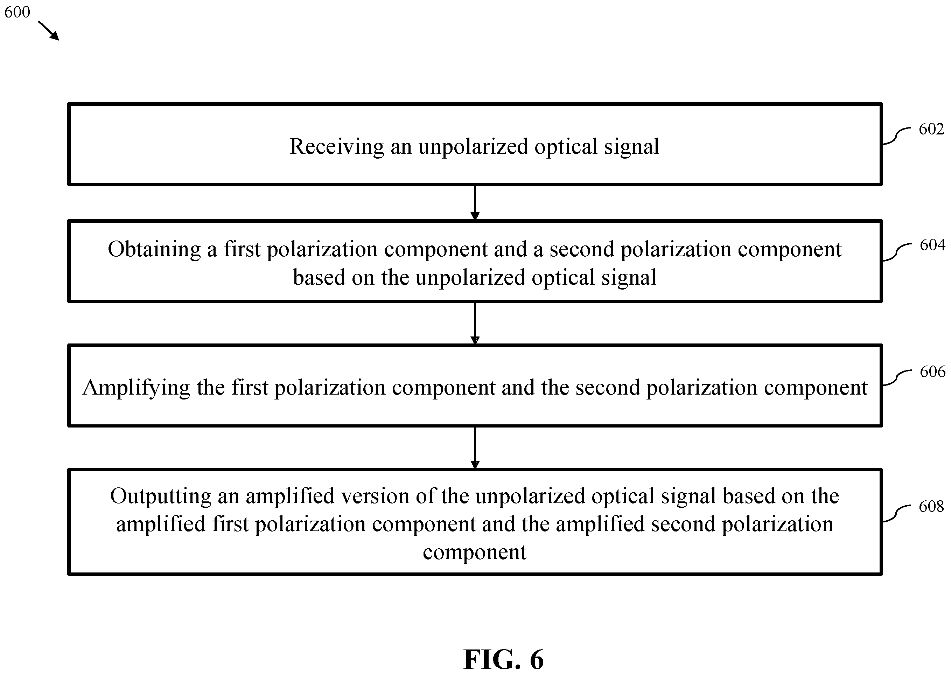

Referring to FIG. 6, a flowchart that illustrates an optical amplification method 600 in accordance with various embodiments of the present disclosure is shown. FIG. 6 will be explained in conjunction with FIG. 2 - FIG. 4. For instance, the optical amplification method 600 may be implemented in one or more of the optical amplification circuits 202, 302, or 402 described in the detailed description of FIG. 2 - FIG. 4, respectively. Starting at block 602, the optical amplification method 600 may include receiving an unpolarized optical signal. In an example, the unpolarized optical signal may be received by the optical amplification circuits 202, 302, or 402 via at least one waveguide. For example, the received unpolarized optical signal may include TE and TM mode components.

At block 604, the optical amplification method 600 may include obtaining a first polarization component and a second polarization component based on the unpolarized optical signal. In an example, the first polarization component and the second polarization component may be obtained by one or more of the input interfaces 204, 304, or 404 by splitting the unpolarized optical signal. In some embodiments, each of the first polarization component and the second polarization component may correspond to the TE mode component. In some more embodiments, each of the first polarization component and the second polarization component may correspond to the TM mode component. In yet some more embodiments, the first polarization component and the second polarization component may correspond to the TE and TM mode components.

At block 606, the optical amplification method 600 may include amplifying the first polarization component and the second polarization component. For example, the amplification of the first polarization component and the second polarization component may include increasing signal strengths and/or power levels of the first polarization component and the second polarization component. In an example, the first polarization component and the second polarization component may be amplified by one or more of the pair of optical amplifiers 206A and 206B, 306A and 306B, or 406A and 406B described in the detailed description of FIG. 2 - FIG. 4, respectively.

At block 608, the optical amplification method 600 may include outputting an amplified version of the unpolarized optical signal based on the amplified first polarization component and the amplified second polarization component. For example, the amplified version of the unpolarized optical signal may be outputted by one or more of the output interfaces 208, 308, or 408. In an example, the amplified version of the unpolarized optical signal may have a signal strength and/or a power level that is greater than a signal strength and/or a power level of the received unpolarized optical signal.

Techniques consistent with the present disclosure provide, among other features, optical circuits, optical amplification circuits, and optical amplification methods for amplifying the unpolarized optical signal. While various exemplary embodiments of the disclosed optical circuits, optical amplification circuits, and optical amplification methods have been described above, it should be understood that they have been presented for purposes of example only, and not limitations. It is not exhaustive and does not limit the present disclosure to the precise form disclosed. Modifications and variations are possible in light of the above teachings or may be acquired from practicing of the present disclosure, without departing from the breadth or scope.

While various embodiments of the present disclosure have been illustrated and described, it will be clear that the present disclosure is not limited to these embodiments only. Numerous modifications, changes, variations, substitutions, and equivalents will be apparent to those skilled in the art, without departing from the spirit and scope of the disclosure, as described in the claims.

## Claims

1. An optical amplification circuit, comprising:
an input interface configured to:
receive an unpolarized optical signal; and
output a first polarization component and a second polarization component based on the unpolarized optical signal;
a pair of optical amplifiers coupled to the input interface, wherein
the pair of optical amplifiers have Polarization-Dependent Gain (PDG) profiles, and
the pair of optical amplifiers is configured to amplify the first polarization component and the second polarization component based on the PDG profiles; and
an output interface coupled to the pair of optical amplifiers, wherein the output interface is configured to output an amplified version of the unpolarized optical signal based on the amplified first polarization component and the amplified second polarization component.

2. The optical amplification circuit of claim 1, wherein the input interface includes:
a polarization splitter configured to split the unpolarized optical signal into the first polarization component and a third polarization component, wherein the third polarization component is orthogonal to the first polarization component; and
a polarization shifter configured to convert the third polarization component to the second polarization component.

3. The optical amplification circuit of claim 2, wherein
each of the first polarization component and the second polarization component corresponds to a transverse electric (TE) mode component, and
the third polarization component corresponds to a transverse magnetic (TM) mode component.

4. The optical amplification circuit of claim 3, wherein each PDG profile of the PDG profiles indicates that an optical gain of a respective optical amplifier of the pair of optical amplifiers is dominant for the TE mode component.

5. The optical amplification circuit of claim 3, wherein
the pair of optical amplifiers includes a first optical amplifier and a second optical amplifier,
the input interface further includes an optical mirror,
the polarization splitter is further configured to:
allow the third polarization component to pass therethrough toward the polarization shifter; and
reflect the first polarization component toward the optical mirror,
the polarization shifter is further configured to output the second polarization component to the first optical amplifier based on the conversion of the third polarization component, and
the optical mirror is configured to direct the first polarization component toward the second optical amplifier.

6. The optical amplification circuit of claim 2, wherein
each of the first polarization component and the second polarization component corresponds to a transverse magnetic (TM) mode component, and
the third polarization component corresponds to a transverse electric (TE) mode component.

7. The optical amplification circuit of claim 6, wherein each PDG profile of the PDG profiles indicates that an optical gain of a respective optical amplifier of the pair of optical amplifiers is dominant for the TM mode component.

8. The optical amplification circuit of claim 6, wherein
the pair of optical amplifiers includes a first optical amplifier and a second optical amplifier,
the input interface further includes an optical mirror,
the polarization splitter is configured to:
allow the first polarization component to pass therethrough toward the first optical amplifier; and
reflect the third polarization component toward the optical mirror,
the optical mirror is configured to direct the third polarization component toward the polarization shifter, and
the polarization shifter is configured to output the second polarization component to the second optical amplifier based on the conversion of the third polarization component.

9. The optical amplification circuit of claim 1, wherein
the output interface includes an optical mirror and a polarization combiner,
the optical mirror is configured to direct the amplified first polarization component toward the polarization combiner, and
the polarization combiner is configured to:
combine the amplified first polarization component and the amplified second polarization component; and
output the amplified version of the unpolarized optical signal based on the combination of the amplified first polarization component and the amplified second polarization component.

10. The optical amplification circuit of claim 9, wherein
the pair of optical amplifiers includes a first optical amplifier and a second optical amplifier,
the output interface further includes a polarization shifter, and
the polarization shifter is between the first optical amplifier and the optical mirror or between the second optical amplifier and the polarization combiner.

11. The optical amplification circuit of claim 1, wherein the first polarization component corresponds to a transverse magnetic (TM) mode component and the second polarization component corresponds to a transverse electric (TE) mode component.

12. The optical amplification circuit of claim 11, wherein
the pair of optical amplifiers includes a first optical amplifier and a second optical amplifier,
the input interface includes a polarization splitter and an optical mirror,
the polarization splitter is configured to:
split the unpolarized optical signal into the first polarization component and the second polarization component;
allow the first polarization component to pass therethrough toward the first optical amplifier; and
reflect the second polarization component toward the optical mirror, and
the optical mirror is configured to direct the second polarization component toward the second optical amplifier.

13. The optical amplification circuit of claim 12, wherein
the PDG profiles include a first PDG profile associated with the first optical amplifier and a second PDG profile associated with the second optical amplifier,
the first PDG profile indicates that an optical gain of the first optical amplifier is dominant for the TM mode component, and
the second PDG profile indicates that an optical gain of the second optical amplifier is dominant for the TE mode component.

14. The optical amplification circuit of claim 1, wherein the pair of optical amplifiers includes a pair of Semiconductor Optical Amplifiers (SOAs).

15. The optical amplification circuit of claim 14, further comprising an amplification control circuit configured to:
generate a drive current for each SOA of the pair of SOAs; and
control, based on the generated drive current, the amplification of each SOA of the pair of SOAs.

16. An optical circuit, comprising:
an optical splitter configured to:
receive an unpolarized input optical signal having a set of characteristics; and
split the unpolarized input optical signal into a plurality of unpolarized optical signals based on the set of characteristics;
a plurality of optical amplification circuits coupled to the optical splitter, wherein
each optical amplification circuit of the plurality of optical amplification circuits includes a pair of optical amplifiers having Polarization-Dependent Gain (PDG) profiles, and
each optical amplification circuit of the plurality of optical amplification circuits is configured to:
receive a respective unpolarized optical signal of the plurality of unpolarized optical signals;
amplify the respective unpolarized optical signal based on the PDG profiles; and
output the respective amplified unpolarized optical signal of a plurality of amplified unpolarized optical signals; and
an optical combiner coupled to the plurality of optical amplification circuits, wherein the optical combiner is configured to:
receive the plurality of amplified unpolarized optical signals;
combine the plurality of amplified unpolarized optical signals; and
output an amplified version of the unpolarized input optical signal based on the combination of the plurality of amplified unpolarized optical signals.

17. The optical circuit of claim 16, wherein the set of characteristics corresponds to at least one of a multi-wavelength band of the unpolarized input optical signal or a power level of the unpolarized input optical signal.

18. The optical circuit of claim 17, wherein each unpolarized optical signal of the plurality of unpolarized optical signals has a specific wavelength band in the multi-wavelength band of the unpolarized input optical signal.

19. The optical circuit of claim 17, wherein each unpolarized optical signal of the plurality of unpolarized optical signals has a specific power ratio relative to the power level of the unpolarized input optical signal.

20. An optical amplification method, comprising:
in an optical amplification circuit that includes a pair of optical amplifiers having Polarization-Dependent Gain (PDG) profiles:
receiving an unpolarized optical signal;
obtaining a first polarization component and a second polarization component based on the unpolarized optical signal;
amplifying the first polarization component and the second polarization component based on the PDG profiles; and
outputting an amplified version of the unpolarized optical signal based on the amplified first polarization component and the amplified second polarization component.
